# EUROPEAN PATENT APPLICATION

(11) **EP 4 766 116 A1**
(43) Date of publication of application: **24.06.2026**
(21) Application number: 25212621.4
(22) Date of filing: 31.10.2025
(51) Int. Cl.: H10K 59/122, H10K 59/35, H10K 59/38, H10K 59/40, H10K 59/80

(54) **DISPLAY DEVICE**

(30) Priority: 17.12.2024 KR 20240188357
(71) Applicant: LG Display Co., Ltd., Seoul, 07336 (KR)
(72) Inventor: HAN, Surin, 10845 Paju-si, Gyeonggi-do (KR); HAN, Jonghyun, 10845 Paju-si, Gyeonggi-do (KR); JEONG, Seongwoong, 10845 Paju-si, Gyeonggi-do (KR); MOON, Younggyu, 10845 Paju-si, Gyeonggi-do (KR)
(74) Representative: Viering, Jentschura & Partner mbB Patent- und Rechtsanwälte

(57) **Abstract**

A display device (100) can include a substrate (110) in which a plurality of sub pixels (SP1, SP2, SP3) is defined, a thin film transistor (120) disposed on the substrate (110), a planarization layer (PNL) disposed on the thin film transistor (120), an organic light emitting diode (130) disposed on the planarization layer (PNL) to correspond to each of the plurality of sub pixels (SP1, SP2, SP3), an encapsulation layer (140) disposed on the organic light emitting diode (130), a touch sensor layer (150), a touch protection layer (TPAS) disposed on the touch sensor layer (150), a black matrix (160) disposed between adjacent sub pixels on the touch protection layer (TPAS), and a plurality of color filters disposed on the touch protection layer (TPAS) to correspond to each of the plurality of sub pixels (SP1, SP2, SP3).

## Description

### BACKGROUND

### Field

The present disclosure relates to a display device, and more particularly, to a display device in which a luminous viewing angle and a reflective visibility are ensured.

### Description of the Related Art

Unlike a liquid crystal display device (LCD) which includes a backlight, an organic light emitting display device (OLED) does not require a separate light source. Therefore, the organic light emitting display device can be manufactured to be light and thin and has process advantages and has low power consumption in accordance with the low voltage driving.

Further, in order to provide more various functions to a user, such a display device includes a touch sensor layer disposed on a display panel and drives the touch sensor layer to provide a function of recognizing a user's touch for the display panel and performing the input processing based on the recognized touch.

In the meantime, the organic light emitting display device includes an anode, a cathode, and an emission layer disposed therebetween. However, the cathode is formed using a metal material having a high reflectance so that the external light is reflected by the metal material, which can made it difficult for a user to easily identify displayed information.

### SUMMARY OF THE DISCLOSURE

A touch sensor layer can be disposed on a display panel with a touch on encapsulation (ToE) structure without including a separate adhesive layer. Further, in order to reduce the above-described external light reflectance, a color filter and a black matrix can be disposed on the touch sensor layer. The black matrix is disposed so as to correspond to a non-emission area and the color filter can be disposed so as to correspond to an emission area of each of the plurality of sub pixels. As the color filter and the black matrix are disposed as described above, the external light reflectance can be reduced without degrading a luminous efficiency.

However, when the color filter and the black matrix are disposed on the touch sensor layer as described above, the external light reflectance can be reduced, but it is needed to ensure the luminance viewing angle and the reflective visibility due to an increased stack structure.

Accordingly, an object to be achieved by the present disclosure is to provide a display device which ensures the luminance viewing angle and the reflective visibility while including a touch sensor layer, a color filter, and a black matrix.

Objects of the present disclosure are not limited to the above-mentioned objects, and other objects, which are not mentioned above, can be clearly understood by those skilled in the art from the following descriptions. Various embodiments of the present disclosure provide a display device according to claim 1. Further embodiments are described in the dependent claims.

According to an aspect of the present disclosure, a display device includes a substrate in which a plurality of sub pixels is defined; a thin film transistor disposed on the substrate; a planarization layer disposed on the thin film transistor, an organic light emitting diode disposed on the planarization layer so as to correspond to each of the plurality of sub pixels; an encapsulation layer disposed on the organic light emitting diode; a touch sensor layer which includes a bridge electrode disposed on the encapsulation layer, a touch insulating layer disposed so as to cover the bridge electrode, and a touch electrode disposed on the touch insulating layer; a touch protection layer disposed on the touch sensor layer; a black matrix which is disposed between adjacent sub pixels on the touch protection layer; and a plurality of color filters which is disposed on the touch protection layer so as to correspond to each of the plurality of sub pixels, the touch insulating layer includes a groove in a position corresponding to the black matrix and the touch electrode is disposed so as to be filled in at least a part of the groove provided in the touch insulating layer.

Other detailed matters of the example embodiments of the present disclosure are included in the detailed description and the drawings.

According to aspects of the present disclosure, in the display device, at least a part of a black matrix is disposed in a groove provided in a touch insulating layer to reduce a cell gap while constantly maintaining a thickness of an encapsulation layer. By doing this, it is advantageous in that the luminance viewing angle is improved while maintaining a touch characteristic to be high.

According to aspects of the present disclosure, if needed or desired, a line width of a black matrix is increased so that a degree of freedom of design of a bridge electrode and a touch electrode is improved to increase easiness of a process of forming a touch sensor layer and a black matrix.

Further, an area of the black matrix is increased to lower an external light reflectance, which results in improvement of the reflective visibility.

According to aspects of the present disclosure, the display device can be manufactured by the substantially same process as the display device of the related art without changing a design of a mask and also provide effects as described above.

The effects according to aspects of the present disclosure are not limited to the contents exemplified above, and other various effects are included in the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a plan view of a display device according to an example embodiment of the present disclosure;
FIG. 2 is a cross-sectional view taken along I-I' of FIG. 1 according to an example embodiment of the present disclosure;
FIG. 3 is an enlarged cross-sectional view of a partial area of a display device according to an example embodiment of the present disclosure;
FIG. 4 is a cross-sectional view of a display device according to a related art;
FIG. 5 is an enlarged cross-sectional view for some components of FIG. 4;
FIG. 6 is a cross-sectional view for explaining an example that a cell gap is reduced in FIG. 4;
FIG. 7 is a view illustrating an effect of a display device according to an example embodiment of the present disclosure; and
FIGS. 8 to 10 are views for explaining a method of manufacturing a display device illustrated in FIG. 7 according to an example embodiment of the present disclosure.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the specification. Further, in the following description of the present disclosure, a detailed explanation of known related technologies can be omitted to avoid unnecessarily obscuring the subject matter of the present disclosure. The terms such as "including," "having," and "comprising" used herein are generally intended to allow other components to be added unless the terms are used with the term "only". Any references to singular can include plural unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms such as "first", "second", and the like are used for describing various components, these components are not confined by these terms. These terms are merely used for distinguishing one component from the other components. Therefore, a first component to be mentioned below can be a second component in a technical concept of the present disclosure. Further, the term "can" fully encompasses all the meanings and coverage of the term "may" and vice versa.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to example embodiments of the present disclosure will be described in detail with reference to accompanying drawings. All the components of each display device/apparatus according to all embodiments of the present disclosure are operatively coupled and configured.

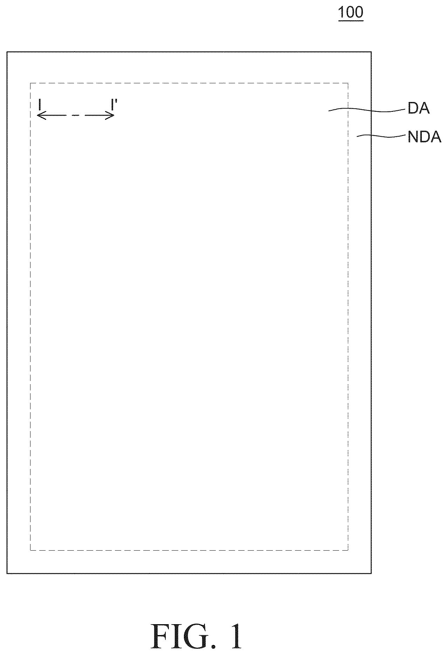

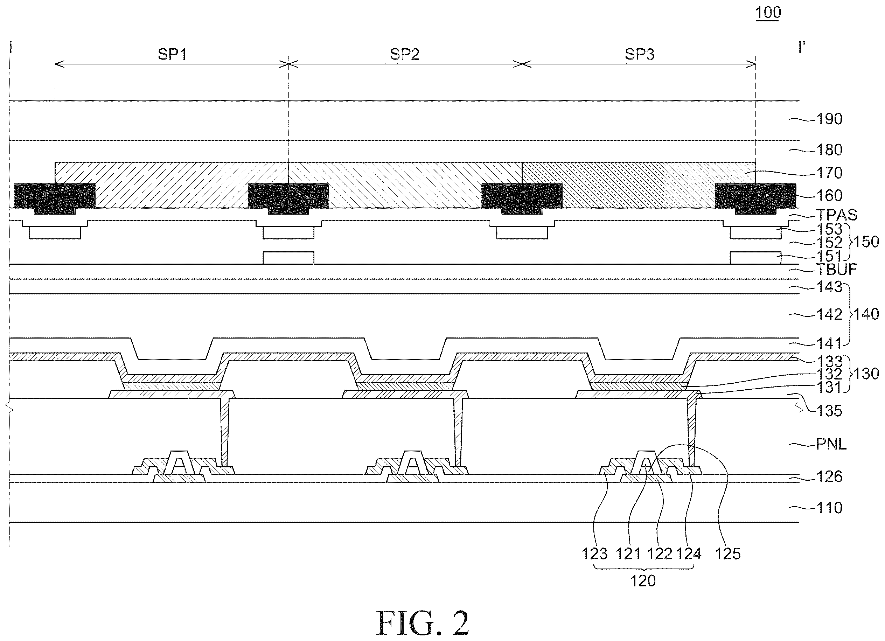

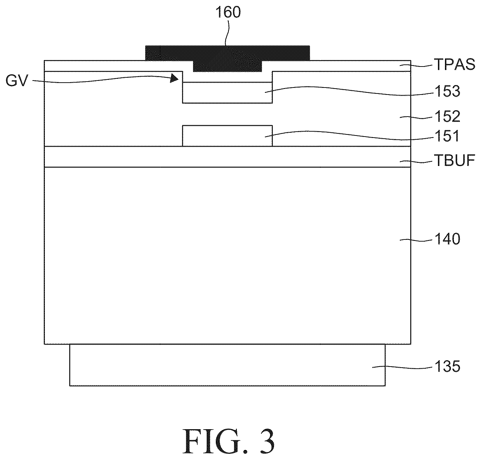

FIG. 1 is a plan view of a display device according to an example embodiment of the present disclosure, FIG. 2 is a cross-sectional view taken along I-I' of FIG. 1, and FIG. 3 is an enlarged cross-sectional view of a partial area of a display device according to an example embodiment of the present disclosure.

Referring to FIGS. 1 to 3, a display device 100 according to an example embodiment of the present disclosure includes a first substrate 110, a thin film transistor 120, a planarization layer PNL, an organic light emitting diode 130, an encapsulation layer 140, a touch sensor layer 150, a touch protection layer TPAS, a black matrix 160, a color filter 170, an over coating layer 180, and a second substrate 190.

The display device 100 includes areas defined by a display area DA and a non-display area NDA. The display area DA is an area where a plurality of pixels is disposed to substantially display images. In the display area DA, pixels including an emission area for displaying images and a driving circuit for driving the pixels can be disposed. The non-display area NDA encloses the display area DA. The non-display area NDA is an area where images are not substantially displayed and various wiring lines, driving ICs, and printed circuit boards for driving the pixels and the driving circuits disposed in the display area DA can be disposed.

The plurality of pixels is disposed in a matrix and each of the plurality of pixels can include a plurality of sub pixels SP1, SP2, and SP3. For example, one pixel can include a first sub pixel SP1, a second sub pixel SP2, and a third sub pixel SP3, but is not limited thereto. The sub pixels SP1, SP2, and SP3 are elements for displaying one color and include an emission area in which light is emitted and a non-emission area in which light is not emitted. For example, each of the plurality of sub pixels can display any one color of red, green, and blue, but is not limited thereto.

Even though in the drawing, it is illustrated that the sub pixels SP1, SP2, and SP3 have the same width, areas can be differently formed according to colors displayed by the sub pixels SP1, SP2, and SP3 in consideration of a luminance and a color temperature.

The first substrate 110 is a base material which supports various elements configuring the display device. For example, the first substrate 110 can be a glass substrate or a plastic substrate. For example, the plastic substrate can be selected from polyimide, polyethersulfone, polyethylene terephthalate, and polycarbonate, but is not limited thereto. When a plastic substrate having flexibility is used, a support member, such as a back plate, can be disposed below the first substrate 110. The plastic substrate having flexibility is thinner and has a weaker rigidity than the glass substrate so that when various elements are disposed, the plastic substrate can be sagged. The back plate supports the first substrate 110 formed of a plastic material so as not to be sagged and protects the display device 100 from moisture, heat, and impacts.

A substrate buffer layer can be disposed on the first substrate 110 to suppress permeation of oxygen or moisture. The substrate buffer layer can be formed as a single layer and can be formed with a multilayered structure as needed. The substrate buffer layer may be a silicon oxide (SiOx) film, a silicon nitride (SiNx) film or a silicon oxynitride (SiON) film, but not limited thereto. The thin film transistor 120 which includes a gate electrode 122, an active layer 121, a source electrode 123, and a drain electrode 124 is disposed on the substrate buffer layer. The thin film transistor 120 is disposed in each of the first sub pixel SP1, the second sub pixel SP2, and the third sub pixel SP3. In the drawing, only a driving thin film transistor, among various thin film transistors which can be included in the display device 100, is illustrated for the convenience of description, but the present disclosure is not limited thereto. Further, in the drawing, it is exemplarily explained that the thin film transistor 120 has a coplanar structure, but the present disclosure is not limited thereto. For example, the active layer 121 is disposed on the first substrate 110 and a gate insulating layer 125 is disposed on the active layer 121 to insulate the active layer 121 and the gate electrode 122 from each other. The gate insulating layer 125 may be formed by inorganic film in a single layer or in multiple layers, for example, the inorganic film in a single layer may be a silicon oxide (SiOx) film, a silicon nitride (SiNx) film or silicon oxynitride (SiON) film, and inorganic films in multiple layers may formed by alternately stacking at least one of one or more silicon oxide (SiOx) films, one or more silicon nitride (SiNx) films and one or more silicon oxynitride (SiON) films, and one or more amorphous silicon (a-Si), but the present disclosure is not limited thereto. Further, an interlayer insulating layer 126 is disposed on the first substrate 110 to insulate the gate electrode 122 from the source electrode 123 and the drain electrode 124. The source electrode 123 and the drain electrode 124 which are in contact with the active layer 121 are disposed on the interlayer insulating layer 126. One of the source electrode 123 and the drain electrode 124 is electrically connected to the organic light emitting diode 130.

The planarization layer PNL can be disposed on the thin film transistor 120. The planarization layer PNL planarizes an upper portion of the thin film transistor 120. The planarization layer PNL can include a contact hole which electrically connects the thin film transistor 120 and the anode 131 of the organic light emitting diode 130. The planarization layer PNL may be an organic insulation layer including an organic insulating material.

For example, the planarization layer PNL may be constituted of one layer. As another example, the planarization layer PNL may include two layers. The planarization layer PNL may include a first planarization layer and a second planarization layer. As another example, the planarization layer PNL may include three or more layers. Example embodiments of the disclosure are not limited thereto.

Active layers of the thin-film transistors may be formed of a semiconductor material, such as an oxide semiconductor, amorphous semiconductor, or polycrystalline semiconductor, but is not limited thereto.

The oxide semiconductor material may have an excellent effect of preventing a leakage current and relatively inexpensive manufacturing cost. The oxide semiconductor may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), indium zinc oxide (IZO), indium gallium tin oxide (IGTO), and indium gallium oxide (IGO), but is not limited thereto.

The polycrystalline semiconductor material has a fast movement speed of carriers such as electrons and holes and thus has high mobility, and has low energy power consumption and superior reliability. The polycrystalline semiconductor may be made of polycrystalline silicon (poly-Si), but is not limited thereto.

The amorphous semiconductor material may be made of amorphous silicon (a-Si), but is not limited thereto.

The organic light emitting diode 130 is disposed on the planarization layer PNL. The organic light emitting diode 130 is disposed in each of the first sub pixel SP1, the second sub pixel SP2, and the third sub pixel SP3. The organic light emitting diode 130 disposed in each of the sub pixels SP1, SP2, and SP3 includes an anode 131, an emission layer 132, and a cathode 133.

The anode 131 is disposed on the planarization layer PNL. The anode 131 can be patterned so as to correspond to each of the plurality of sub pixels SP1, SP2, and SP3. For example, the anode 131 can be separately formed for each of the first sub pixel SP1, the second sub pixel SP2, and the third sub pixel SP3. The anode 131 is formed of a conductive material having a high work function to supply holes to the emission layer 132. The anode 131 can be a transparent conductive layer which is formed of transparent conductive oxide (TCO). For example, the anode 131 can be formed by one or more selected from transparent conductive oxides such as indium tin oxide (ITO), indium zinc oxide (IZO), indium tin zinc oxide (ITZO), tin oxide (SnO₂), zinc oxide (ZnO), indium copper oxide (ICO), and aluminum doped zinc oxide (Al-doped ZnO, AZO), but is not limited thereto.

When the display device 100 is driven as a top emission type, the anode 131 can further include a reflection layer which reflects light emitted from the emission layer 132 toward the cathode 133.

A bank 135 is disposed on the anode 131 and the planarization layer PNL. The bank 135 is disposed on the planarization layer PNL so as to cover an edge of the anode 131. The opening of the bank 135 may expose a portion of the pixel electrode (anode 131) to form the emission area. The opening of the bank 135 may overlap a portion of the pixel electrode (anode 131). The bank 135 defines the plurality of sub pixels SP1, SP2, and SP3. The bank 135 can be formed of an insulating material which insulates anodes 131 of adjacent sub pixels SP1, SP2, and SP3 from each other.

The bank 135 can be a black bank having a high light absorptance. Therefore, the bank 135 can suppress the color mixture between adjacent sub pixels SP1, SP2, and SP3. Further, the black bank can absorb external light which passes through the color filter 170 and the black matrix 160 to be described below to enter the display device 100. Therefore, the reflective visibility can be improved by reducing the external light reflectance. For example, the bank 135 can include an organic material, such as a polyimide resin, an acrylic resin, or a benzocyclobutene resin and a black coloring agent or can be formed with a black resin, but is not limited thereto.

The cathode 133 is disposed on the anode 131. The cathode 133 can be formed of a metal material having a low work function to smoothly supply electrons to the emission layer 132. For example, the cathode 133 can be formed of a metal material selected from calcium (Ca), barium (Ba), aluminum (Al), silver (Ag), and alloys including one or more of them, but is not limited thereto. The cathode 133 is formed on the anode 131 and the emission layer 132 as a single layer. For example, the cathode 133 can be formed over the first sub pixel SP1, the second sub pixel SP2, and the third sub pixel SP3 as a single layer. When the organic light emitting display device 100 is driven as a top emission type, the cathode 133 is formed to have a very small thickness to be substantially transparent.

The emission layer 132 is disposed between the anode 131 and the cathode 133. The emission layer 132 is a layer in which electrons and holes are coupled to emit light. The emission layer 132 can be patterned so as to correspond to each of the plurality of sub pixels SP1, SP2, and SP3. The emission layer 132 can be configured to emit light with the same color as a corresponding sub pixel SP1, SP2, SP3. For example, an emission layer 132 corresponding to the red sub pixel emits red light, an emission layer 132 corresponding to the green sub pixel emits green light, and an emission layer 132 corresponding to the blue sub pixel emits blue light.

In order to improve luminous efficiency, the organic light emitting diode 130 can further include a hole injection layer, a hole transport layer, an electron transport layer, and an electron injection layer. For example, the hole injection layer and the hole transport layer can be disposed between the anode 131 and the emission layer 132 and the electron transport layer and the electron injection layer can be disposed between the emission layer 132 and the cathode 133. Further, a hole blocking layer or an electron blocking layer can be disposed to further improve a recombination efficiency of the holes and electrons in the emission layer 132.

An encapsulation layer 140 is disposed on the organic light emitting diode 130. The encapsulation layer 140 is disposed so as to cover the organic light emitting diode 130. Therefore, the encapsulation layer 140 can protect the organic light emitting diode 130 from moisture, oxygen, and impacts of the outside. The encapsulation layer 140 can be formed with a multilayered structure in which an inorganic layer formed of an inorganic insulating material and an organic layer formed of an organic material are laminated. For example, the encapsulation layer 140 can be configured by at least one organic layer and at least two inorganic layers and have a multilayered structure in which the inorganic layers and the organic layer are alternately laminated, but is not limited thereto.

For example, the encapsulation layer 140 can have a triple layered structure including a first inorganic layer 141, an organic layer 142, and a second inorganic layer 143. In this case, the first inorganic layer 141 and the second inorganic layer 143 can be independently formed of one or more selected from silicon nitride (SiNx), silicon oxide (SiOx), aluminum oxide (AlOx), and silicon oxynitride (SiON), but are not limited thereto. Further, the organic layer 142 can be formed of one or more selected from epoxy resin, acrylic resin, silicon resin, polyimide, polyethylene, and silicon oxycarbide (SIOC), but is not limited thereto.

Alternatively, the encapsulation layer may include a first inorganic encapsulation layer, a first organic encapsulation layer, a second inorganic encapsulation layer, a second organic encapsulation layer, and a third inorganic encapsulation layer stacked sequentially.

The first inorganic encapsulation layer, the second inorganic encapsulation layer, and the third inorganic encapsulation layer may serve to block the penetration of moisture or oxygen. The first inorganic encapsulation layer, the second inorganic encapsulation layer, and the third inorganic encapsulation layer may be made of an inorganic material, for example, an inorganic material such as silicon nitride (SiNx), silicon oxide (SiOx), or aluminum oxide (AlOx). However, the present disclosure is not limited thereto.

The first organic encapsulation layer is disposed between the first inorganic encapsulation layer and the second inorganic encapsulation layer, and the second organic encapsulation layer is disposed between the second inorganic encapsulation layer and the third inorganic encapsulation layer. The first organic encapsulation layer and the second organic encapsulation layer may each have a larger thickness than each of the first inorganic encapsulation layer, the second inorganic encapsulation layer, and the third inorganic encapsulation layer in order to adsorb or block particles that may be produced during a process of manufacturing the display device. The first organic encapsulation layer and the second organic encapsulation layer may fill cracks that may be formed in the first inorganic encapsulation layer and the second inorganic encapsulation layer. The first organic encapsulation layer and the second organic encapsulation layer may planarize an upper portion of the first inorganic encapsulation layer and an upper portion of the second inorganic encapsulation layer by covering particles on the first inorganic encapsulation layer and the second inorganic encapsulation layer respectively. For example, the first organic encapsulation layer may planarize an upper portion of the first inorganic encapsulation layer by covering particles on the first inorganic encapsulation layer. For example, the second organic encapsulation layer may planarize an upper portion of the second inorganic encapsulation layer by covering particles on the second inorganic encapsulation layer. The first organic encapsulation layer and the second organic encapsulation layer may be made of an organic material, and for example, epoxy polymer, acrylic polymer, or the like may be used. However, the present disclosure is not limited thereto.

Meanwhile, the encapsulation layer is not limited to three or five layers, for example, n layers alternately stacked between inorganic encapsulation layer and organic encapsulation layer (where n is an integer greater than 3) may be included.

The touch sensor layer 150 is disposed on the encapsulation layer 140 to impart a touch sensing function to the display device 100. In the display device 100 according to the example embodiment of the present disclosure, the touch sensor layer 150 is formed with a touch on encapsulation (ToE) structure in which an electrode is formed on the encapsulation layer 140 without a separate base material or adhesive member. In this structure, if a distance between the organic light emitting diode 130 and the touch sensor layer 150 is too short, there can be a problem in that a parasitic capacitance is generated to degrade a touch sensitivity. Therefore, the thickness of the encapsulation layer 140 needs to be appropriately adjusted to minimize the parasitic capacitance.

At this time, during a process of forming a touch sensor layer 150, a touch buffer layer TBUF can be disposed between the encapsulation layer 140 and the touch sensor layer 150 to protect the encapsulation layer 140 and the organic light emitting diode 130 disposed therebelow. Further, the touch buffer layer TBUF improves an adhesive strength of the bridge electrode 151 to be described below. The touch buffer layer TBUF can be formed by an inorganic insulating material, and for example, formed by one or more selected from silicon nitride (SiNx), silicon oxide (SiOx), aluminum oxide (AlOx), and silicon oxynitride (SiON), but is not limited thereto.

The touch sensor layer 150 includes a bridge electrode 151, a touch insulating layer 152, and a touch electrode 153 which are disposed on the touch buffer layer TBUF.

First, the touch electrode 153 is an electrode which senses a touch input and is configured by a sensing electrode and a driving electrode and can detect a touch coordinate by sensing a change of the capacitance between the sensing electrode and the driving electrode. For example, the sensing electrode and the driving electrode are disposed on the same planar surface and at least some of the plurality of touch electrodes 153 is electrically connected to the touch electrode 153 with the touch insulating layer 152 therebetween, through the bridge electrode 151 disposed on a different plane.

Specifically, for example, the bridge electrode 151 is disposed on the touch buffer layer TBUF and the touch insulating layer 152 is disposed so as to cover the bridge electrode 151. The touch insulating layer 152 includes a plurality of grooves GV and the plurality of touch electrodes 153 is disposed in the plurality of grooves GV, respectively. The bridge electrode 151 is configured to be electrically connected to at least a part of the plurality of touch electrodes 153 and to this end, the touch insulating layer 152 can include a contact hole. However, the present disclosure is not limited thereto and a configuration of the touch sensor layer 150 can be changed in various ways depending on the design.

The bridge electrode 151 and the touch electrode 153 can be disposed so as to overlap the bank 135. Each of the bridge electrode 151 and the touch electrode 153 can be disposed so as to correspond to a boundary portion of adjacent sub pixels SP1, SP2, and SP3. A width of each of the bridge electrode 151 and the touch electrode 153 is smaller than a width of a corresponding bank 135. In this case, the efficiency of light emitted from the organic light emitting diode 130 can be maintained high.

The bridge electrode 151 and the touch electrode 153 can be formed of a transparent metal material which transmits light, such as indium tin oxide (ITO) or indium zinc oxide (IZO), but are not limited thereto. The bridge electrode 151 and the touch electrode 153 can have various shapes, such as a rectangular shape, an octagonal shape, a circular shape, or a diamond shape, but are not limited thereto.

The touch insulating layer 152 can be formed of an organic insulating material. For example, the touch insulating layer 152 can be formed of a transparent organic insulating material, such as acrylic based resin, polyester based resin, epoxy resin, and silicon based resin, but is not limited thereto.

The touch insulating layer 152 includes a plurality of grooves GV in a position overlapping a bank 135 and a black matrix 160 to be described below. Each of the plurality of touch electrodes 153 is disposed in each of the plurality of grooves GV. For example, the touch electrode 153 is disposed so as to be filled in at least a part of the grooves GV, which will be described in more detail below.

A touch protection layer TPAS is disposed on the touch sensor layer 150. The touch protection layer TPAS is disposed so as to cover the touch insulating layer 152 and the touch electrode 153. The touch protection layer TPAS protects the touch sensor layer 150 so as not to be damaged during a process of forming the black matrix 160 and the color filter 170 on the touch sensor layer 150. Further, the touch protection layer TPAS suppresses permeation of moisture or oxygen from the outside and protects the touch sensor layer 150 so as not to deteriorate. Therefore, the touch protection layer TPAS can be formed of an inorganic insulating material having an excellent barrier property. For example, the touch protection layer TPAS can be formed by one or more inorganic insulating materials selected from silicon nitride (SiNx), silicon oxide (SiOx), aluminum oxide (AlOx), and silicon oxynitride (SiON), but is not limited thereto.

Further, the touch protection layer TPAS can improve the adhesive strength of the black matrix 160 and the color filter 170 disposed thereabove. For example, the touch protection layer TPAS is disposed between the touch sensor layer 150 and the black matrix 160 and the color filter 170 to allow the black matrix 160 and the color filter 170 to be bonded onto the touch sensor layer 150.

As described above, the touch insulating layer 152 includes the plurality of grooves GV and the touch electrode 153 is disposed so as to be filled in at least a part of the plurality of grooves GV. The touch protection layer TPAS is disposed so as to cover top surfaces of the touch insulating layer 152 and the touch electrode 153 to be formed to have a shape corresponding to the top surfaces of the touch insulating layer 152 and the touch electrode 153. Therefore, when the touch electrode 153 is disposed so as to be filled in the plurality of grooves GV, only partially, rather than fully, at least a part of the touch protection layer TPAS can be disposed in the groove GV.

The black matrix 160 and the color filter 170 are disposed on the touch protection layer TPAS. The black matrix 160 and the color filter 170 serve as an anti-reflection layer which satisfactorily transmits light emitted from the organic light emitting diode 130 and reduces the external light reflectance to minimize the degradation of the visibility and the contrast ratio of the display device 100. The black matrix 160 is disposed on the touch protection layer TPAS so as to overlap the bank 135. The black matrix 160 is disposed so as to correspond to each of the plurality of grooves GV provided in the touch insulating layer 152. Therefore, each of the bridge electrode 151, the touch electrode 153, and the black matrix 160 is disposed so as to overlap the bank 135.

The black matrix 160 is formed by a material having a high light absorptance. Therefore, the black matrix 160 absorbs external light to improve a reflective visibility. The black matrix 160 is formed to have a width larger than a width of each of the bridge electrode 151 and the touch electrode 153. Therefore, the bridge electrode 151 and the touch electrode 153 are blocked by the black matrix 160 and are not visible from the outside. Further, the touch electrode 153 has a reflectance higher than that of the black matrix 160 due to the characteristic of the material so that the black matrix 160 is disposed above the touch electrode 153 to improve the problem in that the external light is reflected from the touch electrode 153 to degrade the visibility.

The black matrix 160 can include a base resin and a black material. For example, the base resin can be one or more selected from cardo based resin, epoxy based resin, acrylate based resin, siloxane based resin, and polyimide, but is not limited thereto. For example, the black material can be a black pigment selected from a carbon based pigment, a metal oxide based pigment, and an organic pigment. For example, the carbon based pigment can be carbon black. For example, the metal oxide based pigment can be titanium black (TiNxOy) or Cu-Mn-Fe based black pigment, but is not limited thereto. For example, the organic pigment can be selected from lactam black, perylene black, and aniline black, but is not limited thereto. Further, as the black material, a RGB black pigment including a red pigment, a blue pigment, and a green pigment can be used, but is not limited thereto.

The black matrix 160 is disposed on the touch protection layer TPAS so as to be located between adjacent sub pixels SP1, SP2, and SP3. For example, the black matrix 160 is disposed along a boundary of adjacent sub pixels SP1, SP2, and SP3 and includes an opening corresponding to the sub pixels SP1, SP2, and SP3. Therefore, light emitted from the organic light emitting diode 130 can be emitted to the outside through the opening of the black matrix 160.

A distance between the adjacent black matrices 160 is larger than a distance between adjacent banks 135. In this case, light emitted from the organic light emitting diode 130 is emitted at a wide angle so that it is advantageous in that the luminance viewing angle is excellent.

The black matrix 160 is disposed in a position overlapping each of the plurality of grooves GV provided in the touch insulating layer 152. Therefore, when the touch electrode 153 is disposed so as to be filled in the plurality of grooves GV, only partially, rather than fully, at least a part of the black matrix 160 can be disposed in the groove GV. The black matrix 160 can be disposed so as to be fully filled in a partial area of the groove which is not filled by the touch electrode 153 and the touch protection layer TPAS.

Specifically, at least a part of a bottom surface of the black matrix 160 is disposed in the groove GV to be filled in the groove GV and a top surface of the black matrix 160 is formed to have a width larger than the width of the groove GV. Therefore, a cross-section of the black matrix 160 can be a T-shape.

The color filter 170 is disposed on the touch protection layer TPAS so as to correspond to the plurality of sub pixels SP1, SP2, and SP3. The color filter 170 is disposed so as to cover a side surface and at least a part of a top surface of the black matrix 160.

The color filter 170 is configured to emit light with the same color as a corresponding sub pixel SP1, SP2, SP3. For example, a color filter corresponding to the red sub pixel is a red color filter, a color filter corresponding to the green sub pixel is a green color filter, and a color filter corresponding to the blue sub pixel is a blue color filter.

The color filter 170 includes a transparent base resin and a color development material. For example, the transparent base resin can be one selected from polyacrylate, polymethyl methacrylate, polyimide, polyvinyl alcohol, polyethylene, polypropylene, polystyrene, and polyethylene terephthalate, but is not limited thereto. The color development material absorbs light in a specific wavelength band and transmits light in the other wavelength band. For example, the red color filter includes a red color development material which transmits light in a red wavelength band and absorbs light in green and blue wavelength bands. For example, a red color development material can be a parylene based compound or a diketo-pyrrolopyrrole based compound. For example, a green color development material can be a phthalocyanine based compound. For example, a blue color development material can be a copper phthalocyanine based compound or an anthraquinone based compound. However, the color development material is not limited thereto and any material which transmits light with the red, blue, and green wavelength bands can be used without limitations. The color filter 170 transmits light emitted from the organic light emitting diode 130 included in each sub pixel SP1, SP2, SP3. For example, internal light emitted from the organic light emitting diode 130 included in each of the first sub pixel SP1, the second sub pixel SP2, and the third sub pixel SP3 passes through the color filter 170 to be emitted to the outside. In contrast, when external light is incident, external light corresponding to an absorption wavelength of a color development material included in each color filter 170 is absorbed by the color filter 170. External light which is not absorbed by the color filter 170, among light incident from the outside is reflected from the cathode 133 and then reaches the color filter 170 again. At this time, a part of reflected light corresponding to an absorption wavelength of the color development material included in the color filter 170 is absorbed by the color filter 170 and the remaining light passes through the color filter 170 to be emitted to the outside. Accordingly, degradation of a display quality due to the external light can be minimized by lowering the external light reflectance while maintaining light emitted from the organic light emitting diode 130 to be high.

The over coating layer 180 is disposed above the color filter 170 and the black matrix 160. The over coating layer 180 planarizes top surfaces of the color filter 170 and the black matrix 160. Therefore, the over coating layer 180 can be formed to have a sufficient thickness to planarize the top surfaces of the color filter 170 and the black matrix 160.

Further, the over coating layer 180 has an adhesive characteristic to bond the second substrate 190. For example, the over coating layer 180 can be formed of transparent resin, such as acrylic based resin, silicon based resin, polyester based resin, and epoxy resin, but is not limited thereto. The over coating layer 180 can include a UV blocker or UV absorber that blocks or absorbs light with a wavelength of 400 nm or less. Therefore, the degradation of the display device 100 due to the ultraviolet ray can be delayed. The UV blocker or UV absorber can be used without limitation as long as the UV blocker or UV absorber is a material used in this technical field.

The second substrate 190 is bonded onto the color filter 170 by the over coating layer 180. The second substrate 190 protects the display device 100 from the external environment. The second substrate 190 can be a plastic substrate or a glass substrate. For example, the plastic substrate can be selected from polyimide, polyethersulfone, polyethylene terephthalate, and polycarbonate, but is not limited thereto.

The display device 100 according to the example embodiment of the present disclosure has a structure in which the touch sensor layer 150 is disposed on the encapsulation layer 140 and the black matrix 160 and the color filter 170 are laminated on the touch sensor layer 150. Therefore, it is important to ensure the luminance viewing angle and the reflective visibility due to the structure of the color filter 170 which becomes higher.

In order to ensure the luminance viewing angle and the reflective visibility, a way to reduce a cell gap which is a distance from the organic light emitting diode 130 to a top surface of the black matrix 160 by reducing a thickness of the encapsulation layer 140 or widen a pull back of the black matrix by reducing a line width of the black matrix 160 can be adopted. However, in order to reduce the thickness of the encapsulation layer 140, a thickness of the organic layer 142 which is relatively thick needs to be reduced. However, a flatness of the encapsulation layer 140 needs to be ensured at a predetermined level or higher while reducing a thickness of the organic layer 142 so that an organic material having excellent flatness needs to be used. Therefore, the material of the organic layer 142 is limited and the difficulty of the process for forming the encapsulation layer 140 is increased, which results in lowering of the productivity. Further, when the thickness of the encapsulation layer 140 is reduced, as described above, a parasitic capacitance can be generated between the organic light emitting diode 130 and the touch sensor layer 150, which results in the degradation of the touch sensitivity.

Further, when the way to widen the pull back of the black matrix by reducing the line width of the black matrix 160 is adopted to ensure the luminance viewing angle, there is a limitation in reducing the line width to block the touch electrode 153 and the bridge electrode 152 disposed below the black matrix 160.

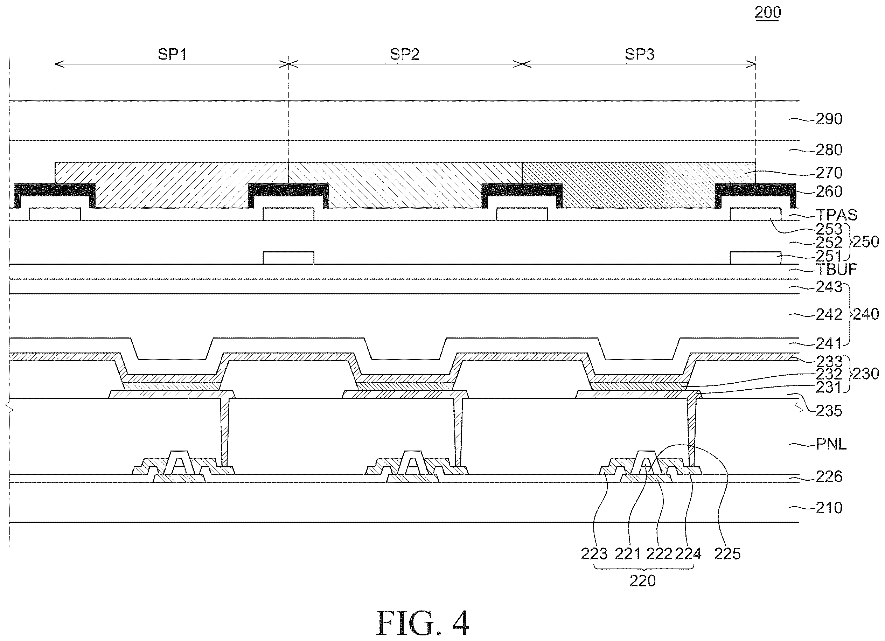

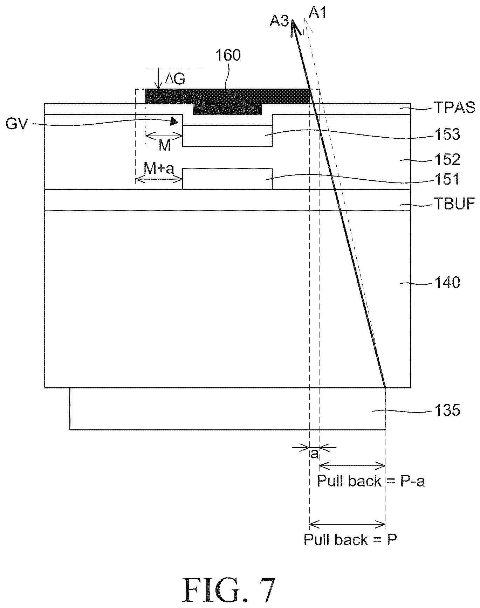

Therefore, it is necessary to ensure the luminance viewing angle and the reflective visibility without causing the problems as described above. Hereinafter, the effect of the display device according to the example embodiment of the present disclosure will be described in detail with reference to FIGS. 4 to 7. In order to explain the effect of the present disclosure, the drawings of the display device according to a related art will be referred to together. FIGS. 4 to 6 are cross-sectional views of a display device according to the related art. In contrast, FIG. 7 is a cross-sectional view illustrating an effect of a display device according to an example embodiment of the present disclosure.

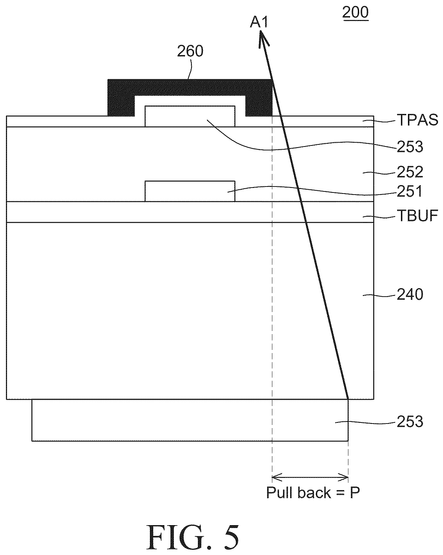

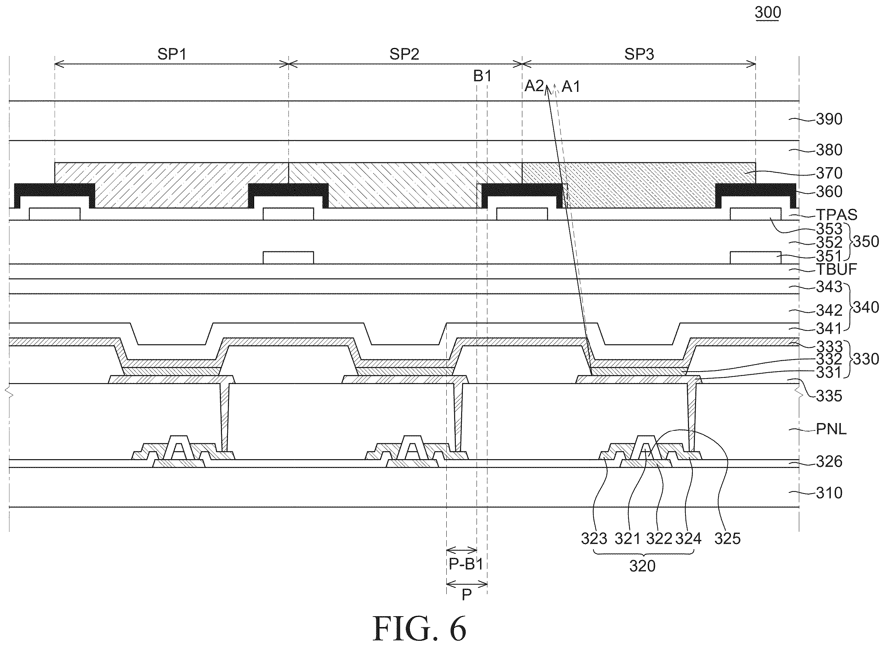

FIG. 4 is a cross-sectional view of a display device according to the related art, FIG. 5 is an enlarged cross-sectional view for some components of FIG. 4, and FIG. 6 is a cross-sectional view for explaining an example that a cell gap is reduced in FIG. 4. In the display device illustrated in FIGS. 4 and 5, a groove is not provided in a touch insulating layer. In the display device illustrated in FIG. 5, for the convenience of description, components other than a bank, an encapsulation layer, a touch buffer layer, a touch sensor layer, a touch protection layer, and a black matrix were not illustrated. A display device illustrated in FIG. 6 is substantially the same as the display device illustrated in FIGS. 4 and 5 except for a thickness of an organic layer of an encapsulation layer. Therefore, a description of repeated components will be omitted.

Referring to FIGS. 4 and 5, in a display device 200 of the related art, a touch insulating layer 252 does not include a plurality of grooves. Therefore, the touch electrode 253 is disposed on a top surface of the touch insulating layer 252 so as to correspond to the bank 253 and a black matrix 260 and a color filter 270 are disposed thereabove. Light emitted from an organic light emitting diode 230 passes through a color filter 270 at a first angle A1. As described above, it is important for the display device 200 in which a touch sensor layer 250 is disposed on an encapsulation layer 240 and the black matrix 260 and the color filter 270 are laminated on the touch sensor layer 250 to ensure the luminance viewing angle and the reflective visibility due to the structure of the color filter 270 which becomes higher.

Therefore, an interval between adjacent black matrices 260 is formed to be larger than an interval between adjacent banks 235 to ensure the luminance viewing angle. Specifically, a pull back defined by an interval between an end of the bank 235 and an end of the black matrix 260 corresponding thereto is widened to ensure the luminance viewing angle. However, in order to suppress the touch electrode 253 from being visible, a line width of the black matrix 260 needed to be maintained at a predetermined level or higher so that there was a limitation in significantly improving the luminance viewing angle. Further, when the pull back is widened, it means that the line width of the black matrix 260 is reduced. However, if the line width of the black matrix 260 is reduced, an area which can absorb the external light is reduced so that it is restricted to lower the external light reflectance. Further, when the external light reflectance is increased, light emitted from the organic light emitting diode 230 and reflected light are emitted together to cause rainbow mura by interference of light, which degrades the display quality.

Therefore, in order to widen the luminance viewing angle, a cell gap can be reduced like a display device 300 illustrated in FIG. 6. The display device 300 illustrated in FIG. 6 is a display device in which a thickness of an organic layer 342 is formed to be thinner than that of the display device 200 illustrated in FIGS. 4 and 5 to reduce the cell gap. As seen from FIG. 6, when the cell gap is reduced by reducing the thickness of the organic layer 342, light emitted from the organic light emitting diode 330 passes through a color filter 370 at a second angle A2 which is larger than that of the display device 200 illustrated in FIGS. 4 and 5. Therefore, the luminance viewing angle is improved. Further, if it is sufficient to emit light emitted from the organic light emitting diode 330 at the first angle A1, as illustrated in FIG. 6, a width of one side of the black matrix 360 is formed to be widened by B1. If the line width of the black matrix 360 is increased as described above, the pull back is reduced by B1 so that there is an advantage of the process in that a process margin between the touch electrode 353 and the black matrix 360 is increased. Further, an area of the black matrix 360 is increased to lower an external light reflectance, which results in improvement of the reflective visibility.

However, as described above, the flatness of the encapsulation layer 340 needs to be maintained at a predetermined level or higher while forming the thickness of the organic layer 342 to be thin so that an organic material having excellent flatness needs to be restrictively used. Therefore, there is a problem in that there is a limitation in selecting the material of the organic layer 342 and the difficulty of the process for forming the encapsulation layer 340 is increased, which results in lowering of the productivity. Further, when the thickness of the encapsulation layer 340 is reduced, there is a problem in that the parasitic capacitance is generated between the organic light emitting diode 130 and the touch sensor layer 350 to degrade the touch sensitivity.

Therefore, the present disclosure provides a display device with improved luminance viewing angle and reflective visibility without causing the problems as described above. Particularly, FIG. 7 is a view illustrating an effect of a display device according to an example embodiment of the present disclosure. In FIG. 7, components of the display device 100 other than the bank 135, the encapsulation layer 140, the touch buffer layer TBUF, the touch sensor layers 151, 152, and 153, the touch protection layer TPAS, and the black matrix 160 may not be shown. Further, the display device illustrated in FIG. 7 is substantially the same as the display device illustrated in FIGS. 1 to 3 according to the present disclosure and a redundant description may be omitted or may be provided briefly.

Referring to FIGS. 1 to 3 and 7, according to the examples of the present disclosure, the touch insulating layer 152 includes a groove GV in a position corresponding to the black matrix 160. As described above, as the groove GV is provided in the position corresponding to the black matrix 160, a partial area of the touch insulating layer 152 which overlaps the black matrix 160 has a relatively small thickness. For example, a thickness of the touch insulating layer 152 at at least a partial area overlapping with the black matrix 160 is smaller than a thickness of the touch insulating layer 152 at other area.

The touch electrode 153 is disposed in the groove GV provided in the touch insulating layer 152. The touch protection layer TPAS and the black matrix 160 are sequentially disposed on the touch sensor layer 150. As it is illustrated in the drawing, if the touch electrode 153 is not fully filled in the groove GV, at least a part of the touch protection layer TPAS and at least a part of the black matrix 160 are disposed in the groove GV. Therefore, a cross-section of the black matrix 160 can be a T-shape. For example, since a part portion of the touch protection layer TPAS is filled in the groove GV, a concave part is formed on a upper surface of the touch protection layer TPAS, thereby a part of the black matrix 160 is filled in the concave part of the touch protection layer TPAS, but not limited thereto.

As described above, as at least a part of the black matrix 160 is disposed in the groove GV provided in the touch insulating layer 152, an effect of reducing the cell gap is provided. As illustrated in FIG. 7, in the display device 100 according to the example embodiment of the present disclosure, at least a part of the black matrix 160 is disposed in the groove GV, so that as compared with the display device 200 of FIG. 4 in which a groove is not provided in the touch insulating layer 152, a cell gap is reduced by ΔG.

Specifically, for example, in the structure of the related art as illustrated in FIG. 5, a total thickness of the encapsulation layer 240 and the touch buffer layer TBUF is formed to be 12 µm and a thickness of the touch insulating layer 252 in which a bridge electrode 251 is not formed is formed to be 2.3 µm. Thereafter, when the touch electrode 253, the touch protection layer TPAS, and the black matrix 260 are sequentially formed on the touch insulating layer 252, a distance from a top surface of the touch insulating layer 252 to a top surface of the black matrix 260 is 1.7 µm and at this time, a pull back can be 6 µm.

In contrast, according to the present disclosure, after the encapsulation layer 140 and the touch buffer layer TBUF are formed with the same thickness and the bridge electrode 151 and the touch insulating layer 152 are formed, when the touch electrode 153 is formed on the touch insulating layer 152 by a method to be described below using a halftone mask, as illustrated in FIG. 7, a touch sensor layer with a structure in which the touch electrode 153 is disposed in the groove GV formed in the touch insulating layer 152 can be formed. Further, when the touch electrode 253, the touch protection layer TPAS, and the black matrix 260 are sequentially formed (as compared with the structure of the related art illustrated in FIG. 5), a distance from the top surface of the touch insulating layer 152 to the top surface of the black matrix 160 and the pull back P can be reduced. For example, ΔG can be 1 µm.

Therefore, when the structure of the related art illustrated in FIG. 5 and the example embodiment of the present disclosure illustrated in FIG. 7 are compared, a total thickness of the encapsulation layer 140 and the touch buffer layer TBUF is 12 µm and the thickness of the touch insulating layer 152 in an area where the electrodes 151 and 153 are not formed is 2.3 µm, which are the same in both structures.

However, in the case of the example embodiment of the present disclosure, the cell gap is reduced by 1 µm so that a distance from the top surface of the touch insulating layer 152 to the top surface of the black matrix 160 is reduced to 0.7 µm. At this time, the pull back P is reduced by a from 6 µm and the viewing angle is increased from the first angle A1 to a third angle A3.

For example, in FIG. 5, when the pull back P is 6 µm and the distance from the encapsulation layer 240 to the black matrix 260 is 16 µm, an angle formed by the pull back P and light emitted at the first angle A1 can be arctan(16/6) = 69.4°.

In contrast, in FIG. 7 according to the example of the present disclosure, when the pull back P is 6 µm and the cell gap is reduced so that the distance from the encapsulation layer 140 to the black matrix 160 is 15 µm, an angle formed by the pull back P and light emitted at the third angle A3 can be arctan(15/6) = 68.2°. Therefore, the luminance viewing angle can be improved by approximately 1.7%.

In the meantime, when there is no need to expand the viewing angle to the third angle A3, as illustrated in FIG. 7 according to the example of the present disclosure, the black matrix 160 can be expanded by a. For example, even though in the structure of FIG. 7, the viewing angle is designed as the first angle A1, if the viewing angle disclosure is satisfied, the pull back (P-a) is 5.626 µm, an expanded distance a of the black matrix 160 is 0.375 µm (one side) and the width of the entire black matrix 160 can be expanded by 0.75 µm. For example, if the width of the black matrix 160 before being expanded is 11 µm, the line width of the black matrix 160 can be increased by 6.8%. In this case, the area of the black matrix 160 is expanded with the same viewing angle characteristic as the related art to absorb more external light. Therefore, the reflective visibility is improved.

Further, as illustrated in FIG. 7 according to the example of the present disclosure, when the area of the black matrix 160 is expanded, line widths of the touch electrode 153 and the bridge electrode 151 can also be expanded so as to correspond to the black matrix 160. Therefore, similar to the black matrix 160, if the line width of each of the touch electrode 153 and the bridge electrode 151 is expanded by 0.75 µm, there is an advantage in that a process margin improved by approximately 25% is ensured to easily perform the process. Further, the resistance of the touch electrode 153 and the bridge electrode 151 is reduced up to 25% and a capacitance Cpen between the touch electrode 153 and a pen is increased due to the increased area of the electrode to provide excellent touch performance.

As described in FIG. 6 according to the related art, when the thickness of the encapsulation layer is reduced to reduce the cell gap, in order to ensure a sufficient flatness with a small thickness, there are a limitation in the material of the encapsulation layer and a difficulty in the process. Further, in this case, as the distance between the organic light emitting diode and the touch sensor layer is reduced, there is a problem in that the touch sensitivity is lowered.

However, in the display device 100 according to the example embodiment of the present disclosure, the cell gap is reduced by forming the groove GV in the touch insulating layer 152 so that there are no limitation in the material of the encapsulation layer 140 and difficulty in the process. For example, the inorganic layer can be formed of one or more selected from silicon nitride (SiNx), silicon oxide (SiOx), aluminum oxide (AlOx), and silicon oxynitride (SiON), but are not limited thereto, and the organic layer can be formed of one or more selected from epoxy resin, acrylic resin, silicon resin, polyimide, polyethylene, and silicon oxycarbide (SIOC), but is not limited thereto. Further, the distance between the organic light emitting diode 130 and the touch sensor layer 150 is sufficiently maintained so that a problem of a touch sensitivity being degraded does not occur in the display device of the present disclosure.

Continuously referring to FIG. 7 according to the example of the present disclosure, it is confirmed that as the cell gap is reduced, the luminance viewing angle is improved. Specifically, in a structure in which the cell gap is not reduced, light emitted from the organic light emitting diode is emitted at the first angle A1, but in a structure in which the cell gap is reduced by the groove GV as illustrated in FIG. 7, light is emitted at the third angle A3 which is larger than the first angle. Therefore, the luminance viewing angle is improved.

Further, according to the example of the present disclosure, even though light emitted from the organic light emitting diode 130 is emitted at the first angle A1, if the luminance viewing angle is sufficient, a width of one side of the black matrix 160 can be expanded by a. When the line width is expanded as described above, the pull back is reduced by a. Therefore, the process margin M between the bridge electrode 151 and the touch electrode 153 and the black matrix 160 can be increased by 2a. Therefore, the degree of freedom of design of the bridge electrode 151 and the touch electrode 153 is improved to have an advantage of the process. Further, when the area of the black matrix 160 is increased, the external light reflectance is further lowered and the rainbow mura is suppressed to improve the reflective visibility.

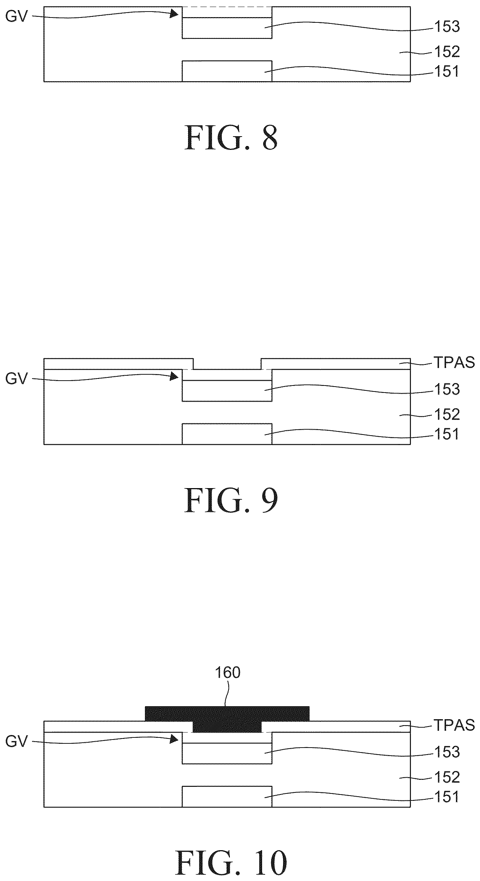

There is an advantage in that a process of forming a groove GV in the touch insulating layer 152 to form the structure as illustrated in FIG. 7 can be implemented with a same process cost as the related art without changing process steps or a mask design. Hereinafter, a method for manufacturing a display device with the structure illustrated in FIG. 7 will be described with reference to FIGS. 8 to 10.

FIGS. 8 to 10 are views for explaining a method of manufacturing a display device illustrated in FIG. 7 according to an example of the present disclosure. In FIGS. 8 to 10, components other than the touch sensor layer 150, the touch protection layer TPAS, and the black matrix are omitted for the convenience of description.

Referring to FIG. 8, a thickness of a touch insulating layer 152 in an area in which a touch electrode 153 is located is reduced using a halftone mask. Therefore, a structure in which a groove GV is formed in the touch insulating layer 152 and a touch electrode 153 is disposed in the groove GV is formed.

At this time, a ratio of the thickness of the touch insulating layer 152 in the area in which the groove GV is not provided to the thickness of the touch insulating layer 152 in the area in which the groove GV is provided can be 1 : 0.2 to 1 : 0.75. More desirably, the ratio can be 1 : 0.5 to 1 : 0.75. In this case, the cell gap is reduced to improve the luminance viewing angle and if necessary, the line width of the black matrix 160 and the touch electrode 153 can be increased so that there is an advantage in that the external light reflectance is lowered and the process margin is improved.

If the thickness of the touch insulating layer 152 in the area in which the groove GV is provided is less than 0.5 times the thickness of the touch insulating layer 152 in the area in which the groove GV is not provided, the depth of the groove GV is large so that there can be a limitation in the planarization of the top surface of the black matrix 160. To be more specific, if the thickness of the touch insulating layer 152 in the area in which the groove GV is provided is reduced to 0.3 times the thickness of the touch insulating layer 152 in the area in which the groove GV is not provided, the black matrix 160 is deeply formed in the groove GV in an area overlapping the touch electrode 153. Therefore, the top surface of the black matrix 160 is not formed to be flat. Therefore, there can be a limitation in the planarization of the layers formed above the black matrix 160 and the uneven surface can affect the optical characteristic.

Further, if the thickness of the touch insulating layer 152 in the area in which the groove GV is provided is less than 0.5 times the thickness of the touch insulating layer 152 in the area in which the groove GV is not provided, the interval between the bridge electrode 151 and the touch electrode 153 is narrowed. For example, if the thickness of the touch insulating layer 152 in the area in which the groove GV is provided is reduced to 0.3 times the thickness of the touch insulating layer 152 in the area in which the groove GV is not provided, the interval between the bridge electrode 151 and the touch electrode 153 is reduced to 70%. In this case, the parasitic capacitance between the touch electrode 153 and the bridge electrode 151 is increased and the parasitic capacitance between the touch electrode 153 and the cathode 133 is also increased to degrade the touch performance. Further, the interval between the bridge electrode 151 and the touch electrode 153 is narrow so that a defect, such as short-circuit can occur during the process of forming an electrode.

In contrast, if the thickness of the touch insulating layer 152 in the area in which the groove GV is provided exceeds 0.75 times the thickness of the touch insulating layer 152 in the area in which the groove GV is not provided, an amount of reduced cell gap is insignificant so that the luminance viewing angle may not be significantly improved.

Referring to FIG. 9, the touch protection layer TPAS is formed by a deposition process and at least a part of the touch protection layer TPAS is disposed in the groove GV.

Referring to FIG. 10, the black matrix 160 is formed on the touch protection layer TPAS by the photolithography process. At this time, at least a part of the black matrix 160 is disposed in the groove GV. Therefore, the cell gap can be reduced without reducing the thickness of the encapsulation layer 130.

The deeper the depth of the groove GV formed in the touch insulating layer 152, the lower the cell gap. Therefore, as described above, if the thickness of the touch insulating layer 152 in the area in which the groove GV is provided is equal to or less than 0.3 times the thickness of the touch insulating layer 152 in the area in which the groove GV is not provided, the defect, such as short-circuit can occur. In order to suppress the problem as described above, the depth of the groove GV is formed within a limited range so that the cell gap can be reduced within a limited range according to the depth of the groove GV.

For example, according to the example embodiment of the present disclosure, an amount of reduced cell gap can be 0.5 µm to 1.5 µm or 1 µm to 1.5 µm and in this case, a line width of one side of the black matrix 160 can be expanded by 0.5 µm to 0.8 µm, but is not limited thereto.

If the amount of reduced cell gap is less than 0.5 µm, light emitted from the organic light emitting diode 130 may not be emitted at a wide angle so that the luminance viewing angle improvement is insignificant and it is difficult to expand the line width. In the meantime, if the amount of reduced cell gap exceeds 1.5 µm, an interval between the organic light emitting diode 130 and the touch sensor layer 150 is narrowed to 0.2 µm to 0.5 µm so that there can be a problem in that the parasitic capacitance is increased and thus the touch sensitivity is degraded.

In summary, in the display device 100 according to the example embodiment of the present disclosure, at least a part of the black matrix 160 is disposed in the groove GV provided in the touch insulating layer 152 to reduce the cell gap without adjusting the thickness of the encapsulation layer 140. Therefore, the luminance viewing angle is improved and if necessary, the line width of the black matrix 160 is increased so that the degree of freedom of design of the bridge electrode 151 and the touch electrode 153 can be increased and the reflective visibility and the touch characteristic can be improved.

The example embodiments of the present disclosure can also be described as follows:
According to an aspect of the present disclosure, there is provided a display device. The display device includes a substrate in which a plurality of sub pixels is defined; a thin film transistor disposed on the substrate; a planarization layer disposed on the thin film transistor; an organic light emitting diode disposed on the planarization layer so as to correspond to each of the plurality of sub pixels; an encapsulation layer disposed on the organic light emitting diode; a touch sensor layer which includes a bridge electrode disposed on the encapsulation layer, a touch insulating layer disposed so as to cover the bridge electrode, and a touch electrode disposed on the touch insulating layer; a touch protection layer which is disposed on the touch sensor layer; a black matrix which is disposed between adjacent sub pixels on the touch protection layer; and a plurality of color filters which is disposed on the touch protection layer so as to correspond to each of the plurality of sub pixels, wherein the touch insulating layer includes a groove in a position corresponding to the black matrix and the touch electrode is disposed so as to be filled in at least a part of the groove provided in the touch insulating layer.

A ratio of a thickness of the touch insulating layer in an area in which the groove is not provided to a thickness of the touch insulating layer in an area in which the groove is provided can be 1 : 0.2 to 1 : 0.75.

At least a part of the touch protection layer can be disposed in the groove.

At least a part of the black matrix can be disposed in the groove.

At least a part of a bottom surface of the black matrix can be disposed in the groove. In this case, a width of a top surface of the black matrix can be larger than a width of the groove.

A cross-section of the black matrix can be a T-shape. A bottom portion of the black matrix in the T-shape can completely fill a remaining part of the groove defined by the touch protection layer.

The organic light emitting diode can include an anode disposed on the planarization layer so as to correspond to each of the plurality of sub pixels; an emission layer disposed on the anode; and a cathode disposed on the emission layer, and the display device can further include a bank disposed on the planarization layer so as to expose at least a part of the anode, and the bank can be a black bank.

Each of the bridge electrode, the touch electrode, and the black matrix can be disposed so as to overlap the bank.

A width of the black matrix can be larger than a width of each of the bridge electrode and the touch electrode.

A distance between adjacent black matrixes can be larger than a distance between adjacent banks. A distance between the black matrix and an adjacent black matrix can be larger than a distance between the bank and an adjacent bank.

A concave part is formed at a top surface of touch protection layer corresponding to the groove of the touch insulating layer, and a bottom portion of the black matrix in the T-shape completely fills the concave part at the top surface of the touch protection layer.

A width of the concave part is less than a width of the groove.

A width of a bottom surface of the black matrix is less than a width of each of the bridge electrode and the touch electrode, and a width of a top surface of the black matrix is larger than the width of each of the bridge electrode and the touch electrode.

According to another aspect of the present disclosure, there is provided a display device. The display device comprises: an encapsulation layer; a touch sensor layer including a bridge electrode disposed on the encapsulation layer, a touch insulating layer disposed to cover the bridge electrode, and a touch electrode disposed on the touch insulating layer; a touch protection layer disposed on the touch sensor layer; a black matrix disposed between adjacent sub pixels on the touch protection layer, wherein the touch insulating layer includes a groove in a position corresponding to the black matrix, and wherein the touch electrode is disposed to be filled in at least a part of the groove provided in the touch insulating layer.

According to another aspect of the present disclosure, there is provided a display panel. The display panel comprises: an encapsulation layer; a touch sensor layer including a bridge electrode disposed on the encapsulation layer, a touch insulating layer disposed to cover the bridge electrode, and a touch electrode disposed on the touch insulating layer; a touch protection layer disposed on the touch sensor layer; a black matrix disposed between adjacent sub pixels on the touch protection layer, wherein the touch insulating layer includes a groove in a position corresponding to the black matrix, and wherein the touch electrode is disposed to be filled in at least a part of the groove provided in the touch insulating layer.

## Claims

1. A display device (100), comprising:
a substrate (110) in which a plurality of sub pixels (SP1, SP2, SP3) is defined;
a thin film transistor (120) disposed on the substrate (110);
a planarization layer (PNL) disposed on the thin film transistor (120);
an organic light emitting diode (130) disposed on the planarization layer (PNL) to correspond to each of the plurality of sub pixels (SP1, SP2, SP3);
an encapsulation layer (140) disposed on the organic light emitting diode (130);
a touch sensor layer (150) including a bridge electrode (151) disposed on the encapsulation layer (140), a touch insulating layer (152) disposed to cover the bridge electrode (151), and a touch electrode (153) disposed on the touch insulating layer (152);
a touch protection layer (TPAS) disposed on the touch sensor layer (150);
a black matrix (160) disposed between adjacent sub pixels on the touch protection layer (TPAS); and
a plurality of color filters (170) disposed on the touch protection layer (TPAS) to correspond to each of the plurality of sub pixels (SP1, SP2, SP3),
wherein the touch insulating layer (152) includes a groove (GV) in a position corresponding to the black matrix (160), and
wherein the touch electrode (153) is disposed to be filled in at least a part of the groove (GV) provided in the touch insulating layer (152).

2. The display device (100) according to claim 1, wherein a ratio of a thickness of the touch insulating layer (152) in an area in which the groove (GV) is not provided to a thickness of the touch insulating layer (152) in an area in which the groove (GV) is provided is 1 : 0.2 to 1 : 0.75.

3. The display device (100) according to claim 2, wherein the ratio of the thickness of the touch insulating layer (152) in the area in which the groove (GV) is not provided to the thickness of the touch insulating layer (152) in the area in which the groove (GV) is provided is 1 : 0.5 to 1 : 0.75.

4. The display device (100) according to any of claims 1 to 3, wherein at least a part of the touch protection layer (TPAS) is disposed in the groove (GV) of the touch insulating layer (152).

5. The display device (100) according to any of claims 1 to 4, wherein at least a part of the black matrix (160) is disposed in the groove (GV) of the touch insulating layer (152).

6. The display device (100) according to any of claims 1 to 5, wherein at least a part of a bottom surface of the black matrix (160) is disposed in the groove (GV) of the touch insulating layer (152).

7. The display device (100) according to claim 6, wherein a width of a top surface of the black matrix (160) is larger than a width of the groove (GV) of the touch insulating layer (152).

8. The display device (100) according to any of claims 1 to 7, wherein a cross-section of the black matrix (160) is a T-shape.

9. The display device (100) according to claim 8, wherein a concave part is formed at a top surface of touch protection layer corresponding to the groove of the touch insulating layer, and a bottom portion of the black matrix (160) in the T-shape completely fills a remaining part of the groove (GV) defined by the touch protection layer (TPAS).

10. The display device (100) according to any of claims 1 to 9, wherein the organic light emitting diode (130) includes:
an anode (131) disposed on the planarization layer (PNL) to correspond to each of the plurality of sub pixels (SP1, SP2, SP3);
an emission layer (132) disposed on the anode (131); and
a cathode (133) disposed on the emission layer (132),
wherein the display device (100) further comprises a bank (135) disposed on the planarization layer (PNL) to expose at least a part of the anode (131), and
wherein the bank (135) is a black bank.

11. The display device (100) according to claim 10, wherein each of the bridge electrode (151), the touch electrode (153), and the black matrix (160) is disposed to overlap the bank (135).

12. The display device (100) according to claim 10 or 11, wherein a distance between the black matrix (160) and an adjacent black matrix (160) is larger than a distance between the bank (135) and an adjacent bank (135).

13. The display device (100) according to any of claims 1 to 12, wherein a width of the black matrix (160) is larger than a width of each of the bridge electrode (151) and the touch electrode (153).

14. The display device according to claim 9, wherein a width of the concave part is less than a width of the groove.

15. The display device according to claim 1, wherein a width of a bottom surface of the black matrix is less than a width of each of the bridge electrode and the touch electrode, and a width of a top surface of the black matrix is larger than the width of each of the bridge electrode and the touch electrode.
